# EUROPEAN PATENT SPECIFICATION

(11) **EP 2 561 186 B1**
(45) Date of publication and mention of the grant of the patent: **12.08.2015**
(21) Application number: 11720556.7
(22) Date of filing: 01.04.2011
(51) Int. Cl.: F01D 21/00, F01D 25/16, F01D 21/04

(54) **ARRANGEMENT FOR DETECTING AXIAL MOVEMENT OF A SHAFT**
ANORDNUNG ZUR ERFASSUNG EINER AXIALEN BEWEGUNG EINER WELLE
AGENCEMENT DESTINÉ À DÉTECTER UN MOUVEMENT AXIAL D'UN ARBRE

(30) Priority: 20.04.2010 FI 20105422
(43) Date of publication of application: 27.02.2013
(73) Proprietor: Wärtsilä Finland Oy, 65380 Vaasa (FI)
(72) Inventor: NORDMAN, Tom, FI-65280 Vaasa (FI)
(74) Representative: Berggren Oy Ab
(86) International application number: PCT/FI2011/050280
(87) International publication number: WO 2011/131828

(56) References cited:
- GB-A- 947 791
- US-A- 4 287 758
- US-B2- 7 018 165

## Description

### Technical field of the invention

The present invention relates to an arrangement for detecting axial movement of a shaft, as defined in the preamble of claim 1. The arrangement comprises two parts that are arranged into sliding contact with each other, the shaft being attached to one of the parts and the surface of one of the parts being made of an electrically conductive material.

### Background of the invention

There are many different applications where a rotating shaft encounters both radial and axial loads. Quite often the axial forces act only in one direction during normal operating conditions of a device, but abnormal operating conditions might cause axial forces acting in the direction that is opposite to the normal direction. Because there is in practice always some axial clearance in bearings that are designed to carry axial loads in both directions, there is also axial movement of the shaft when the direction of the axial forces change. In some applications this might be acceptable, but in some cases the movement of the shaft might be an indication of undesired operating conditions. Therefore, there is a need for a simple arrangement that can be used to detect axial movement of a shaft. For example, in a turbocharger for an internal combustion engine, axial movement of the shaft could give an indication of pre-surge and surge that might damage the turbocarger.

Prior art documents US 7 018 165 B2, US 4 287 758 A, GB 947 791 A and US2005/193715 A1 disclose various arrangements for detecting axial movement of a shaft.

### Summary of the invention

The object of the present invention is to provide a simple and reliable arrangement for detecting axial movement of a shaft. The characterizing features of an arrangement according to the present invention are given in the characterizing part of claim 1. According to the invention, an arrangement for detecting axial movement of a shaft comprises a first part and a second part, which second part comprises a surface being made of an electrically conductive material, which electrically conductive surface can be brought into sliding contact with the first part and apart from it, the shaft being attachable to the first part or to the second part. The arrangement further comprises a sensor being arranged in the first part, which sensor is made at least partly of an electrically conductive material and comprises a first area and a second area, which first area is electrically connected to the electrically conductive surface of the second part. The second area is in electrical contact with the electrically conductive surface of the second part when the first part and the second part are in sliding contact with each other so that a closed electrical circuit is formed. When the first part and the second part are at a distance from each other, the second area is at a distance from the electrically conductive surface of the second part so that an open electrical circuit is formed. The arrangement also comprises means for detecting opening and closing of the electrical circuit.

During normal operating conditions of the shaft, the two parts may be either in contact with each other or at a distance from each other. Abnormal operating conditions move the shaft so that the electrical circuit is either opened or closed. Opening or closing of the circuit is detected, and this gives an indication of the movement of the shaft. With an arrangement according to the present invention, axial movement of the shaft can be easily detected. Depending on the application where the arrangement is used, this information can be used for different purposes. For instance, the device where the arrangement is used can be stopped automatically, its speed can be reduced or other operating parameters can be adjusted.

According to an embodiment of the present invention, the means for detecting opening and closing of the electrical circuit comprise means for measuring the resistance between the sensor and the surface of the second part. The means could be for instance an ohmmeter. Resistance measurement is a simple means for detecting opening and closing of the electrical circuit.

According to another embodiment of the present invention, the second part is a thrust collar that can be arranged around the shaft. This means that the sensor is arranged in a load carrying part against which the thrust collar lies. If the sensor is arranged in the load carrying part, no separate parts for attaching the sensor are needed.

According to another embodiment of the present invention, an arrangement for detecting axial movement of a shaft comprises a second load carrying part and a second thrust collar, the second thrust collar comprising a surface being made of an electrically conductive material, which electrically conductive surface can be brought into sliding contact with the second load carrying part. The arrangement also comprises a second sensor that is arranged in the second load carrying part. The second load carrying part is arranged to carry axial forces that are opposite to the axial forces carried by the first load carrying part, and the second sensor is made at least partly of an electrically conductive material and comprises a first area and a second area, the first area being electrically connected to the electrically conductive surface of the second thrust collar. The second area is in electrical contact with the electrically conductive surface of the second thrust collar when the second load carrying part and the second thrust collar are in sliding contact with each other so that a closed electrical circuit is formed. When the second load carrying part and the second thrust collar are at a distance from each other, the second area is at a distance from the electrically conductive surface of the second thrust collar so that an open electrical circuit is formed. The arrangement further comprises means for detecting opening and closing of the electrical circuit.

With a second sensor that is arranged in a second thrust collar more information on the operating conditions of the shaft can be obtained. If the axial load is during normal operating conditions carried by the first load carrying part and there is a clearance between the second load carrying part and the second thrust collar, a change in the direction of axial force is first detected as opening of the electrical circuit connected to the first thrust collar and then as closing of the electrical circuit connected to the second thrust collar.

According to another embodiment of the present invention, the arrangement is used in a turbocharger for detecting pre-surge or surge. The arrangement enables an early detection of pre-surge or surge and may prevent damages to the turbocharger.

Features of other embodiments of the present invention are given in the dependent claims.

### Brief description of the drawings

Fig. 1 shows a cross-sectional view of a turbocharger for an internal combustion engine.
Fig. 2 shows in more detail the thrust collar arrangement of the turbocharger of Fig. 1.
Fig. 3 shows a sensor arrangement in connection with the thrust collar arrangement of Fig. 1.

### Detailed description of the invention

Some embodiments of the present invention are now described with reference to the accompanying drawings.

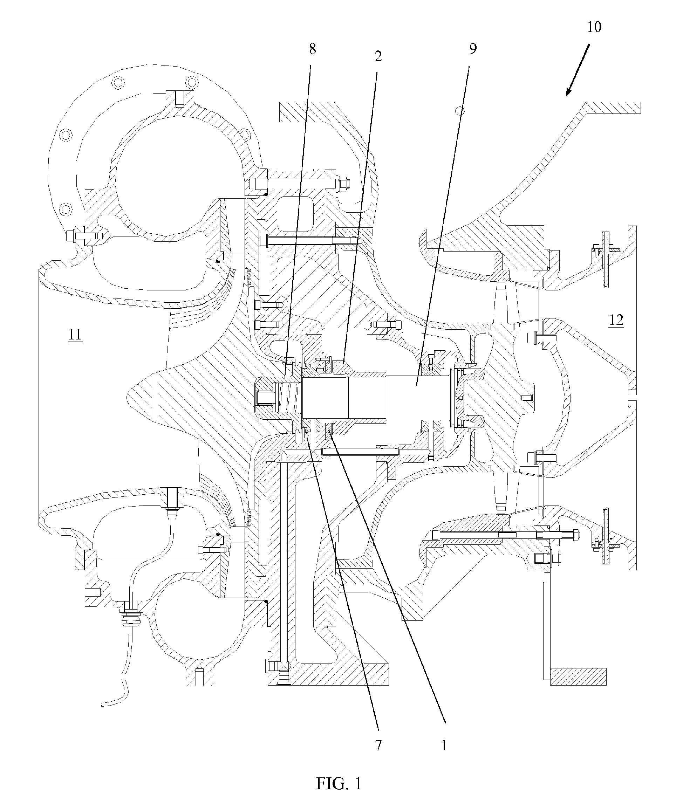

Figs. 1-3 show an embodiment of the present invention, where the arrangement is used to detect axial movement of the shaft 9 of a turbocharger 10 for an internal combustion engine. When the turbocharger 10 works under normal operating conditions, the axial loads of the shaft 9 are carried by a thrust collar 2. The thrust collar 2 is arranged to rotate against a load carrying part 1 having a bearing surface 1a. The thrust collar comprises a surface 2a that is made of an electrically conductive material. The thrust collar 2 and its surface 2a can be made of the same material, for example a metal or an alloy. Alternatively, the thrust collar 2 can be coated with an electrically conductive material. It is not necessary that the whole outer surface of the thrust collar 2 is made of an electrically conductive material, but it is enough that the surface 2a that is in contact with the bearing surface 1a is electrically conductive. The load carrying part 1 is made of any suitable material that can be used in bearings, such as a metal or an alloy. The bearing surface 1a may be made of the same or different material than the body of the load carrying part 1. For instance, it is possible that the body of the load carrying part 1 is made of steel, while the bearing surface 1a is made of a material with a low coefficient of friction, such as a copper based alloy or a white metal.

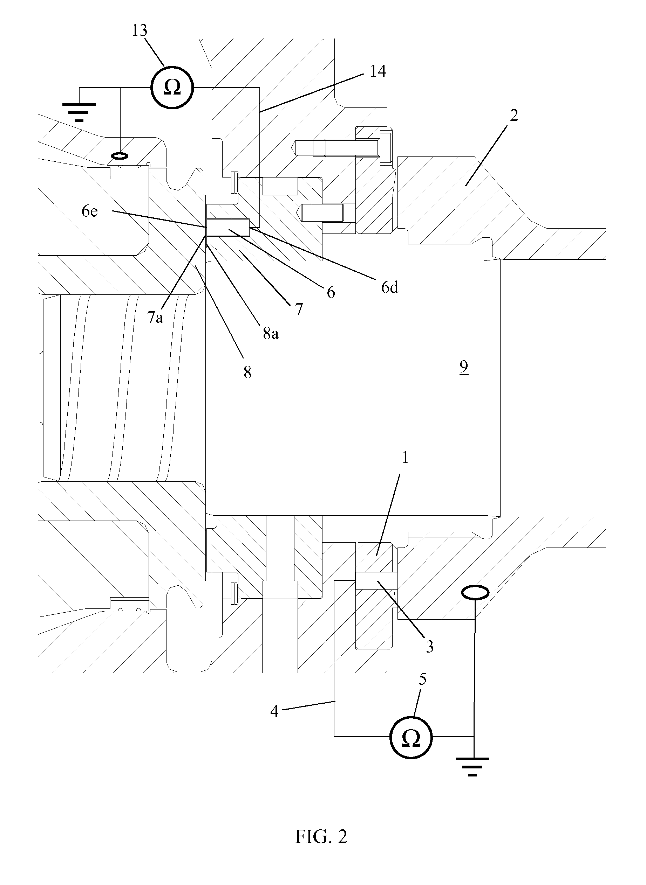

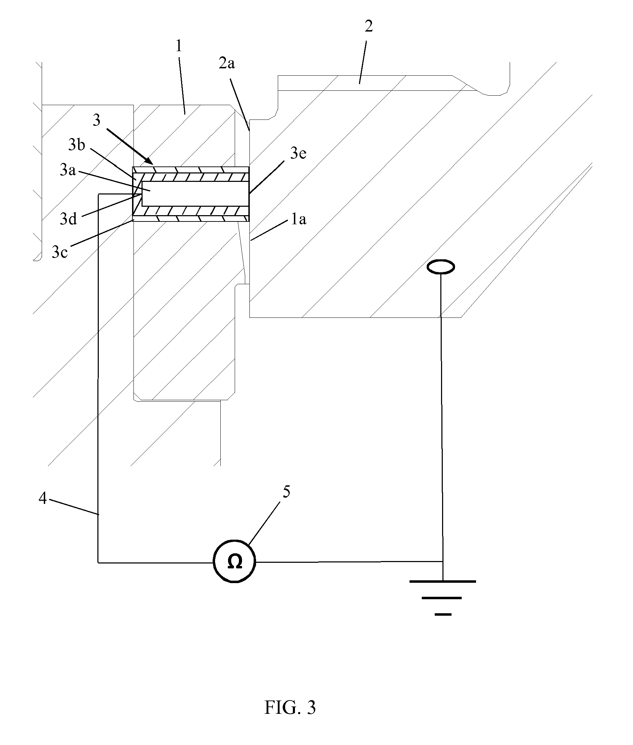

To detect movement of the shaft 9, a sensor 3 has been arranged in the load carrying part 1. The sensor 3 shown in Fig. 2 and in more detail in Fig. 3 comprises three parts. The sensor comprises a sensor core 3a that is made of an electrically conductive material. The material of the sensor core 3a could be a metal or an alloy, but also other electrically conductive solid materials, such as certain polymers, can be used. An insulating layer 3b that is made of an electrically non-conductive material has been arranged around the sensor core 3a. The insulating layer 3b could be made of for instance some electrically non-conductive polymer. The sensor core 3a and the insulating layer 3b are inside a sensor body 3c that is used to fasten the sensor 3 to the load carrying part 1. The insulating layer 3b and the sensor body 3c are not necessarily essential parts of the sensor 3. If the load carrying part 1 is made of a material that is electrically non-conductive, it is not necessary to insulate the sensor core 3a from the load carrying part 1. Also, if the sensor core 3a is made of a material that has suitable mechanical properties for direct fastening to the load carrying part 1, it is not necessary to have a sensor body 3c. This means that the sensor core 3a can form the whole sensor 3. The insulating layer 3b and the sensor body 3c can also be the same part. If the sensor body 3c is made of an electrically non-conductive material, it can work both as the insulating layer 3b and the sensor body 3c. If the sensor 3 comprises an insulating layer 3b and/or the load carrying part 1 is made of an electrically non-conductive material, the sensor body 3c can be made of an electrically conductive material.

At the first end of the sensor 3 there is provided a first area 3d, which is electrically connected through a conductor 4 to the electrically conductive surface 2a of the thrust collar 2. The first area 3d is covered by the insulating layer 3b. It should be noted, however, that it is not necessary that the conductor 4 is connected to the thrust collar 2. It is also possible that the conductor 4 is connected to some other part in the construction, if that part is electrically connected to the thrust collar 2. For instance, if the frame of the construction where the arrangement is used is made of an electrically conductive material and at least the surface 2a of the thrust collar 2 is made of an electrically conductive material and electrical current can flow from the frame to the thrust collar 2, the conductor 4 can be attached to the frame. At the second end of the sensor 3 there is provided a second area 3e, that is in electrical contact with the electrically conductive surface 2a of the thrust collar 2. The thrust collar 2 is also connected to ground. Since the sensor core 3a is made of an electrically conductive material, a closed electrical circuit is formed when the load carrying part 1 and the thrust collar 2 are in sliding contact with each other. The electrical circuit is provided with an ohmmeter 5 that measures the resistance between the sensor 3 and the surface 2a of the thrust collar 2.

It is not necessary to have direct mechanical contact between the second area 3e and the surface 2a of the thrust collar 2. There might be a thin layer of a lubricant and thus a narrow gap between the second area 3e and the surface 2a of the thrust collar 2, and despite of that the parts are in electrical contact with each other. The lubricant can be electrically conductive, or the gap might be so narrow that current can flow from one part to the other.

When the turbocharger 10 encounters abnormal operating conditions, the shaft 9 might move, which causes that a gap is formed between the thrust collar 2 and the load carrying part 1. When a gap is formed between these two parts, also the second area 3e of the sensor 3 is separated from the electrically conductive surface 2a of the thrust collar 2. This is detected as an increase of the resistance between the sensor 3 and the thrust collar 2. It will be appreciated by those skilled in the art that also other means than an ohmmeter 5 could be used to detect opening of the electrical circuit. For instance, the electrical circuit could be provided with a voltage source and a current meter. The current meter would then measure current in the electrical circuit and detect opening of the circuit as a drop of the current.

In an embodiment of the present invention, an arrangement for detecting axial movement of a shaft 9 is used in a turbocharger 10 to detect pre-surge or surge. The turbocharger 10 comprises a shaft 9, a first thrust collar 2, a second thrust collar 8, a first sensor 3 and a second sensor 6. For the sake of clarity, sensor cores, insulating layers and sensor bodies are not shown in Fig. 2, and the electrical circuits in Fig. 2 and Fig. 3 are shown schematically only. The sensors 3, 6 are not shown in Fig. 1. The sensors 3, 6 can be made of one part, or they can comprise an insulating layer and a sensor body. Both sensors 3, 6 have a first area 3d, 6d at the first end of the sensor 3, 6 and a second area 3e, 6e at the second end of the sensor 3, 6. The first thrust collar 2 rotates against the bearing surface 1a of a first load carrying part 1. A second load carrying part 7 having a second bearing surface 7a is arranged so that the second thrust collar 8 can rotate against the second bearing surface 7a. However, under normal operating conditions, there is a gap between the second thrust collar 8 and the second load carrying part 7. Those parts of the surfaces of the thrust collars 2, 8 that can be in contact with the bearing surfaces 1a, 7a are made of an electrically conductive material.

The first sensor 3 and the second sensor 6 are electrically connected from the first areas 3d, 6d through conductors 4, 14 to the electrically conductive surfaces 2a, 8a of the first thrust collar 2 and second thrust collar 8, respectively. The electrical circuits are also provided with ohmmeters 5, 13 that can detect opening and closing of the circuits. Alternatively, current meters or some other means could be used to detect opening and closing of the electrical circuits.

Under normal operating conditions of the turbocharger 10, the axial load in the shaft 9 is towards the compressor side 11 of the turbocharger 10. The axial load is thus carried by the first load carrying part 1, of which bearing surface 1a is in sliding contact with the first thrust collar 2. Consequently, also the second area 3e of the first sensor 3 is in contact with the surface 2a of the first thrust collar 2 and the electrical circuit where the first sensor 3 is located is closed. When the turbocharger 9 encounters pre-surge, an axial force opposite to the normal axial force affects the shaft 9 and strives to move the shaft 9 towards the turbine side 12 of the turbocharger 10. When the force is large enough, the shaft 9 moves towards the turbine side 12 of the turbocharger 10 so that the first thrust collar 2 and the first load carrying 1 part are at a distance from each other. This will also cut the electrical contact between the first sensor 3 and the first thrust collar 2. The electrical circuit is thus opened and this is detected as an increase in resistance between the sensor 3 and the first thrust collar 2.

If the force caused by pre-surge is large enough or the turbocharger 10 encounters surge, the shaft 9 will move such a distance that contact between the second thrust collar 8 and the second load carrying part 7 is formed. This means that also the second area 6e of the second sensor 6 will be in contact with the second thrust collar 8 and the second electrical circuit is closed. This will be detected as a decrease in resistance between the second sensor 6 and the second thrust collar 8.

Rotation speed of the shaft 9 can be measured to give additional information on the operating conditions of the turbocharger 10. When the information regarding the rotation speed is combined with the information regarding the axial movements of the shaft 9, a more accurate view of the operating conditions of the turbocharger 10 can be obtained and corrective actions can be taken in time when pre-surge or surge is detected. Possible actions that can be taken to end a pre-surge or surge situation include increasing the flow through the compressor of the turbocharger 10 or decreasing the charge pressure.

Many variations of the present invention are possible within the scope of the accompanying claims. For instance, it is possible that the first part is a thrust collar, and the sensor is thus arranged in the thrust collar. It would also be possible that the first part and the second part are not parts of a bearing, but separate parts that are used only for detecting axial movements of the shaft. For example, either the first part or the second part could be a sleeve that is arranged around the shaft and could be brought into contact with the other part that is stationary. Although the sensors are presented in the figures as elongated objects, many other forms are possible. For instance, the sensors could be plates that are made of a metal or some other suitable material. The arrangement could also be used in many other applications than turbochargers. For instance, it could be used in connection with a propeller shaft in a ship for detecting propeller cavitation. It could also be used to detect axial movements of a crankshaft of an internal combustion engine.

## Claims

1. An arrangement for detecting axial movement of a shaft (9), the arrangement comprising a first part (1) and a second part (2), which second part (2) comprises a surface (2a) being made of an electrically conductive material, which electrically conductive surface (2a) can be brought into sliding contact with the first part (1) and apart from it, the shaft (9) being attachable to the first part (1) or to the second part (2), a sensor (3) being arranged in the first part (1), which sensor (3) is made at least partly of an electrically conductive material and comprises a first area (3d) and a second area (3e), which first area (3d) is electrically connected to the electrically conductive surface (2a) of the second part (2), and which second area (3e) is in electrical contact with the electrically conductive surface (2a) of the second part (2) when the first part (1) and the second part (2) are in sliding contact with each other so that a closed electrical circuit is formed, and which second area (3e) is at a distance from the electrically conductive surface (2a) of the second part (2) when the first part (1) and the second part (2) are at a distance from each other so that an open electrical circuit is formed, the arrangement further comprising means (5) for detecting opening and closing of the electrical circuit, **characterized in that** the first part (1) is a load carrying part (1) and the second part (2) is a thrust collar (2) that can be arranged around the shaft (9) and in sliding contact with the load carrying part (1).

2. An arrangement according to claim 1, **characterized in that** the means (5) for detecting opening and closing of the electrical circuit comprise means (5) for measuring the resistance between the sensor (3) and the surface of the second part (2).

3. An arrangement according to claim 1 or 2, **characterized in that** the sensor (3) comprises an electrically conductive sensor core (3a) and an insulating layer (3b) arranged around the sensor core (3a).

4. An arrangement according to claim 3, **characterized in that** the insulating layer (3b) also covers the first area (3d) at the first end of the sensor (3).

5. An arrangement according to claim 3 or 4, **characterized in that** the sensor core (3a) and the insulating layer (3b) are arranged inside a sensor body (3c).

6. An arrangement according to any of the preceding claims, **characterized in that** the arrangement comprises a second load carrying part (7) and a second thrust collar (8), which second thrust collar (8) comprises a surface (8a) being made of an electrically conductive material, which electrically conductive surface (8a) can be brought into sliding contact with the second load carrying part (7) and apart from it, the arrangement further comprising a second sensor (6) being arranged in the second load carrying part (7), which second load carrying part (7) is arranged to carry axial forces that are opposite to the axial forces carried by the first load carrying part (1), and which second sensor (6) is made at least partly of an electrically conductive material and comprises a first area (6d) and a second area (6e), which first area (6d) is electrically connected to the electrically conductive surface (8a) of the second thrust collar (8), and which second area (6e) is in electrical contact with the electrically conductive surface (8a) of the second thrust collar (8) when the second load carrying part (7) and the second thrust collar (8) are in sliding contact with each other so that a closed electrical circuit is formed, and which second area (6e) is at a distance from the electrically conductive surface (8a) of the second thrust collar (8) when the second load carrying part (7) and the second thrust collar (8) are at a distance from each other so that an open electrical circuit is formed, the arrangement further comprising means (13) for detecting opening and closing of the electrical circuit.

7. An arrangement according to any of claims 1-6, **characterized in that** the arrangement is used in a turbocharger (10) for detecting pre-surge or surge.

## Patentansprüche

1. Anordnung zum Erfassen einer axialen Bewegung einer Welle (9), wobei die Anordnung einen ersten Teil (1) und einen zweiten Teil (2) umfasst, wobei der zweite Teil (2) eine Oberfläche (2a) umfasst, die aus einem elektrisch leitfähigen Material hergestellt ist, wobei die elektrisch leitfähige Oberfläche (2a) in Schleifkontakt mit dem ersten Teil (1) gebracht und von ihm getrennt werden kann, wobei die Welle (9) an dem ersten Teil (1) oder an dem zweiten Teil (2) befestigt werden kann, wobei ein Sensor (3) in dem ersten Teil (1) angeordnet ist, wobei der Sensor (3) wenigstens teilweise aus einem elektrisch leitfähigen Material hergestellt ist und einen ersten Bereich (3d) und einen zweiten Bereich (3e) umfasst, wobei der erste Bereich (3d) elektrisch mit der elektrisch leitfähigen Oberfläche (2a) des zweiten Teils (2) verbunden ist und wobei sich der zweite Bereich (3e) in elektrischem Kontakt mit der elektrisch leitfähigen Oberfläche (2a) des zweiten Teils (2) befindet, wenn sich der erste Teil (1) und der zweite Teil (2) in Schleifkontakt miteinander befinden, so dass ein geschlossener elektrischer Kreis gebildet wird, und wobei sich der zweite Bereich (3e) in einer Entfernung von der elektrisch leitfähigen Oberfläche (2a) des zweiten Teils (2) befindet, wenn sich der erste Teil (1) und der zweite Teil (2) in einem Abstand voneinander befinden, so dass ein offener elektrischer Kreis gebildet wird, wobei die Anordnung ferner Mittel (5) zum Erfassen des Öffnens und des Schließens des elektrischen Kreises umfasst, **dadurch gekennzeichnet, dass** der erste Teil (1) ein tragender Teil (1) ist und der zweite Teil (2) ein Druckring (2) ist, der um die Welle (9) und in Schleifkontakt mit dem tragenden Teil (1) angeordnet werden kann.

2. Anordnung nach Anspruch 1, **dadurch gekennzeichnet, dass** die Mittel (5) zum Erfassen des Öffnens und des Schließens des elektrischen Kreises Mittel (5) zum Messen des Widerstandes zwischen dem Sensor (3) und der Oberfläche des zweiten Teils (2) umfassen.

3. Anordnung nach Anspruch 1 oder 2, **dadurch gekennzeichnet, dass** der Sensor (3) einen elektrisch leitfähigen Sensorkern (3a) und eine isolierende Schicht (3b) um den Sensorkern (3a) umfasst.

4. Anordnung nach Anspruch 3, **dadurch gekennzeichnet, dass** die isolierende Schicht (3b) ebenfalls den ersten Bereich (3d) an dem ersten Ende des Sensors (3) abdeckt.

5. Anordnung nach Anspruch 3 oder 4, **dadurch gekennzeichnet, dass** der Sensorkern (3a) und die isolierende Schicht (3b) innerhalb des Sensorgehäuses (3c) angeordnet sind.

6. Anordnung nach einem der vorhergehenden Ansprüche, **dadurch gekennzeichnet, dass** die Anordnung einen zweiten tragenden Teil (7) und einen zweiten Druckring (8) umfasst, wobei der zweite Druckring (8) eine Oberfläche (8a) umfasst, die aus einem elektrisch leitfähigen Material hergestellt ist, wobei die elektrisch leitfähige Oberfläche (8a) in Schleifkontakt mit dem zweiten tragenden Teil (7) gebracht und von ihm getrennt werden kann, wobei die Anordnung ferner einen zweiten Sensor (6) umfasst, der in dem zweiten tragenden Teil (7) angeordnet ist, wobei der zweite tragende Teil (7) dafür angeordnet ist, axiale Kräfte zu tragen, die zu den durch den ersten tragenden Teil (1) getragenen axialen Kräften entgegengesetzt sind, und wobei der zweite Sensor (6) wenigstens teilweise aus einem elektrisch leitfähigen Material hergestellt ist und einen ersten Bereich (6d) und einen zweiten Bereich (6e) umfasst, wobei der erste Bereich (6d) elektrisch mit der elektrisch leitfähigen Oberfläche (8a) des zweiten Druckrings (8) verbunden ist und wobei sich der zweite Bereich (6e) in elektrischem Kontakt mit der elektrisch leitfähigen Oberfläche (8a) des zweiten Druckrings (8) befindet, wenn sich der zweiten tragende Teil (7) und der zweite Druckring (8) in Schleifkontakt miteinander befinden, so dass ein geschlossener elektrischer Kreis gebildet wird, und wobei sich der zweite Bereich (6e) in einer Entfernung von der elektrisch leitfähigen Oberfläche (8a) des zweiten Druckrings (8) befindet, wenn sich der zweiten tragende Teil (7) und der zweite Druckring (8) in einem Abstand voneinander befinden, so dass ein offener elektrischer Kreis gebildet wird, wobei die Anordnung ferner Mittel (13) zum Erfassen des Öffnens und des Schließens des elektrischen Kreises umfasst.

7. Anordnung nach einem der Ansprüche 1 bis 6, **dadurch gekennzeichnet, dass** die Anordnung in einem Turbolader (10) zum Erfassen von Vorpumpen oder Pumpen verwendet wird.

## Revendications

1. Agencement destiné à détecter un mouvement axial d'un arbre (9), l'agencement comprenant une première partie (1) et une seconde partie (2), laquelle seconde partie (2) comprend une surface (2a) faite d'un matériau électriquement conducteur, laquelle surface électriquement conductrice (2a) peut être amenée en contact coulissant avec la première partie (1) et à distance de celle-ci, l'arbre (9) pouvant être fixé à la première partie (1) ou à la seconde partie (2), un capteur (3) étant agencé dans la première partie (1), lequel capteur (3) est fait au moins partiellement d'un matériau électriquement conducteur et comprend une première zone (3d) et une seconde zone (3e), laquelle première zone (3d) est connectée électriquement à la surface électriquement conductrice (2a) de la seconde partie (2), et laquelle seconde zone (3e) est en contact électrique avec la surface électriquement conductrice (2a) de la seconde partie (2) lorsque la première partie (1) et la seconde partie (2) sont en contact coulissant l'une avec l'autre de sorte qu'un circuit électrique fermé est formé, et laquelle seconde zone (3e) est à distance de la surface électriquement conductrice (2a) de la seconde partie (2) lorsque la première partie (1) et la seconde partie (2) sont à distance l'une de l'autre de sorte qu'un circuit électrique ouvert est formé, l'agencement comprend en outre un moyen (5) pour détecter l'ouverture et la fermeture du circuit électrique, **caractérisé en ce que** la première partie (1) est une partie supportant une charge (1) et la seconde partie (2) est une bague d'appui (2) qui peut être agencée autour de l'arbre (9) et en contact coulissant avec la partie supportant une charge (1).

2. Agencement selon la revendication 1, **caractérisé en ce que** le moyen (5) pour détecter l'ouverture et la fermeture du circuit électrique comprend un moyen (5) pour mesurer la résistance entre le capteur (3) et la surface de la seconde partie (2).

3. Agencement selon la revendication 1 ou 2, **caractérisé en ce que** le capteur (3) comprend un noyau de capteur électriquement conducteur (3a) et une couche isolante (3b) agencée autour du noyau de capteur (3a).

4. Agencement selon la revendication 3, **caractérisé en ce que** la couche isolante (3b) couvre également la première zone (3d) sur la première extrémité du capteur (3).

5. Agencement selon la revendication 3 ou 4, **caractérisé en ce que** le noyau de capteur (3a) et la couche isolante (3b) sont agencés à l'intérieur d'un corps de capteur (3c).

6. Agencement selon l'une quelconque des revendications précédentes, **caractérisé en ce que** l'agencement comprend une seconde partie supportant une charge (7) et une seconde bague d'appui (8), laquelle seconde bague d'appui (8) comprend une surface (8a) faite d'un matériau électriquement conducteur, laquelle surface électriquement conductrice (8a) peut être amenée en contact coulissant avec la seconde partie supportant une charge (7) et à distance de celle-ci, l'agencement comprenant en outre un second capteur (6) agencé dans la seconde partie supportant une charge (7), laquelle seconde partie supportant une charge (7) est agencée pour supporter des forces axiales qui sont opposées aux forces axiales supportées par la première partie supportant une charge (1), et lequel second capteur (6) est fait au moins partiellement d'un matériau électriquement conducteur et comprend une première zone (6d) et une seconde zone (6e), laquelle première zone (6d) est connectée électriquement à la surface électriquement conductrice (8a) de la seconde bague d'appui (8), et laquelle seconde zone (6e) est en contact électrique avec la surface électriquement conductrice (8a) de la seconde bague d'appui (8) lorsque la seconde partie supportant une charge (7) et la seconde bague d'appui (8) sont en contact coulissant l'une avec l'autre de sorte qu'un circuit électrique fermé est formé, et laquelle seconde zone (6e) est à distance de la surface électriquement conductrice (8a) de la seconde bague d'appui (8) lorsque la seconde partie supportant une charge (7) et la seconde bague d'appui (8) sont à distance l'une de l'autre de sorte qu'un circuit électrique ouvert est formé, l'agencement comprenant en outre un moyen (13) pour détecter l'ouverture et la fermeture du circuit électrique

7. Agencement selon l'une des revendications 1 à 6, **caractérisé en ce que** l'agencement est utilisé dans un turbocompresseur (10) pour détecter une pré-crête ou une crête.
